# EUROPEAN PATENT APPLICATION

(11) **EP 4 578 360 A1**
(43) Date of publication of application: **02.07.2025**
(21) Application number: 23856388.6
(22) Date of filing: 26.07.2023
(51) Int. Cl.: A47L 11/40, G02B 27/09, G01S 17/931

(54) **MULTI-LINE LASER AND CLEANING DEVICE**

(30) Priority: 26.08.2022 CN 202211034834
(71) Applicant: Beijing Roborock Technology Co., Ltd., Beijing 102206 (CN)
(72) Inventor: WANG, Miao, Beijing 102206 (CN)
(74) Representative: Winter, Brandl - Partnerschaft mbB
(86) International application number: PCT/CN2023/109418
(87) International publication number: WO 2024/041298

(57) **Abstract**

A multi-line laser and a cleaning device. The multi-line laser (100) comprises: a substrate (10), wherein N laser light sources (11) are provided on the substrate (10), and N is a positive integer greater than or equal to 2; a collimation component (20), configured to collimate laser light emitted by the laser light sources (11); and a shaping component (30), the shaping component (30) comprising N shaping regions that are respectively configured to shape N beams of laser light that is emitted by the N laser light sources (11) and collimated, so as to form linear laser light.

## Description

### CROSS-REFERENCE TO RELATED APPLICATION

This application claims priority to the Chinese Patent Application No. 202211034834.5, filed on August 26, 2022, which is incorporated herein by reference in its entirety as a part of the present application.

### TECHNICAL FIELD

The present disclosure relates to the field of laser detection technologies, and in particular to a multi-line laser device and cleaning equipment.

### BACKGROUND ART

With the advancement of technology, mobile robots such as AGV robots, service robots, and cleaning robots have been extensively utilized in industrial sites, commercial venues, residential homes and other scenes. Currently, autonomous mobile robots generally employ a binocular vision obstacle avoidance solution, a 3D ToF obstacle avoidance solution, and a line laser obstacle avoidance solution. Among them, the line laser obstacle avoidance solution, due to its relatively low cost and relatively high measurement accuracy, has gradually emerged as a preferred obstacle avoidance solution for consumer mobile robots such as the cleaning robots. In a line laser obstacle avoidance apparatus, the direction (an inclination angle of linear laser) and the quantity of the linear laser emitted by a line laser device are crucial factors for determining an obstacle avoidance effect.

### SUMMARY OF THE INVENTION

Some embodiments of that present disclosure provide a multi-line laser device, and the multi-line laser device includes:
a substrate, N laser light sources being arranged on the substrate, wherein N is a positive integer and N is greater than or equal to 2;
a collimating component, configured to collimate lasers emitted by the laser light sources; and
a shaping component, the shaping component including N shaping regions which are configured to shape N collimated lasers emitted by the N laser light sources respectively to form linear lasers.

In some embodiments, each of the N shaping regions is one of a vertical shaping region, a horizontal shaping region and an inclined shaping region.

In some embodiments, light spots, formed by the lasers emitted by the laser light sources that pass through the collimating component and are then projected onto the shaping component, fall into the shaping regions corresponding to the laser light sources.

In some embodiments, the position and the size of the light spot are determined by at least one of a position and a light emitting direction of the laser light source corresponding to the light spot, a characteristic of the collimating component, and a distance between the collimating component and the shaping component.

In some embodiments, the substrate and the shaping component are located on two sides of the collimating component respectively, the substrate is located on a focal plane of the collimating component, and the substrate is arranged to be perpendicular to the optical axis of the collimating component.

In some embodiments, the center of the substrate or the centrosymmetric point of two laser light sources on the substrate is located on the optical axis of the collimating component.

In some embodiments, an extinction device is arranged between adjacent shaping regions.

In some embodiments, the multi-line laser device further includes an extinction cylinder configured to accommodate the substrate, the collimating component and the shaping component.

In some embodiments, at least some of the laser light sources are configured to emit lasers at different time and/or emit lasers simultaneously.

In some embodiments, the laser light sources corresponding to mutually parallel linear lasers emit lasers simultaneously; and the laser light sources corresponding to mutually intersecting linear lasers emit lasers at different time.

In some embodiments, the shaping region includes at least one of a Powell prism, a cylindrical mirror and a wave mirror.

Some embodiments of the present disclosure provide cleaning equipment including the multi-line lase device described in the foregoing embodiments.

### BRIEF DESCRIPTION OF THE DRAWINGS

The accompanying drawings herein, which are incorporated into the Description and constitute a part of the Description, show embodiments conforming to the present disclosure, and are used to explain the principles of the present disclosure together with the Description. Apparently, the accompanying drawings in the following description show merely some embodiments of the present disclosure, and those of ordinary skill in the art can also derive other accompanying drawings from these accompanying drawings without creative efforts. In the accompanying drawings:
FIG. 1 is a schematic diagram of an obstacle avoidance scene of cleaning equipment provided by some embodiments of the present disclosure;
FIG. 2 is a schematic diagram of an obstacle avoidance scene of cleaning equipment provided by some embodiments of the present disclosure;
FIG. 3 is a schematic structural diagram of a multi-line laser device provided by some embodiments of the present disclosure;
FIG. 4 is a schematic structural diagram of a substrate provided by some embodiments of the present disclosure;
FIG. 5 is a schematic structural diagram of a multi-line laser device provided by some embodiments of the present disclosure; and
FIG. 6 is a schematic diagram of an obstacle avoidance scene of cleaning equipment provided by some embodiments of the present disclosure.

### DETAILED DESCRIPTION

To make the objectives, technical solutions and advantages of the present disclosure clearer, the present disclosure will be further described in detail below with reference to the accompanying drawings. Apparently, the described embodiments are only some, but not all of the embodiments of the present disclosure. All other embodiments acquired by those of ordinary skills in the art without creative efforts based on the embodiments in the present disclosure are within the protection scope of the present disclosure.

It should also be noted that, the terms "including", "containing", or any other variants thereof are intended to cover the nonexclusive inclusion, such that a commodity or apparatus including a series of elements includes not only those elements, but also other elements not listed explicitly or elements inherent to such a commodity or apparatus. Without more limitations, the element defined by the phrase "including a ..." does not exclude the existence of other same elements in the commodity or apparatus including the element.

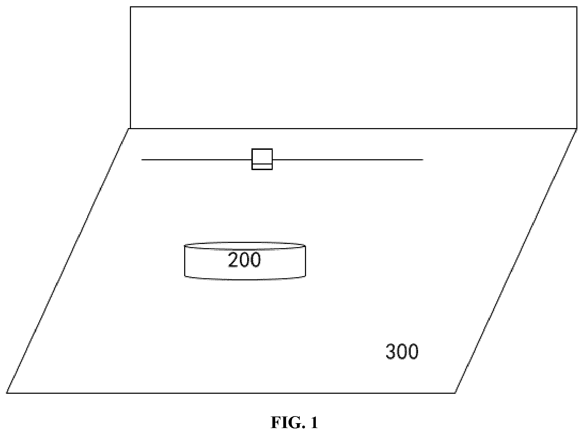

In this field, a single-line laser obstacle avoidance apparatus generally cannot meet obstacle avoidance requirements in complex environments. However, a multi-line laser obstacle avoidance apparatus requires the integration of a plurality of single-line laser devices. As a result, the cost and integration complexity are greatly increased, which is unacceptable for consumer products. Specifically, cleaning equipment, such as a sweeping robot and a sweeping and mopping machine usually adopt a line laser obstacle avoidance solution. In a line laser obstacle avoidance apparatus, the direction (a linear laser inclination angle) and the quantity of linear lasers emitted by a linear laser device are crucial factors for determining an obstacle avoidance effect. FIG. 1 is a schematic diagram of an obstacle avoidance scene of cleaning equipment provided by some embodiments of the present disclosure. As shown in FIG. 1, automatic cleaning equipment 200, such as a sweeping robot, automatically walks on a working surface 300, for example, the ground. The automatic cleaning equipment 200 performs obstacle avoidance based on the use of a line laser for obstacle avoidance. The linear laser obstacle avoidance apparatus emits a linear laser obliquely downward, which is horizontal to the working surface. If the horizontal laser linear irradiates on an obstacle, the horizontal linear laser will form a bend point. By comparing with the part of the laser that the horizontal linear laser emits and hits the ground, the distance to the obstacle can be determined, and the obstacle can be avoided based on the distance information.

The obstacle avoidance solution in the above way can only identify obstacles on the ground, but cannot identify an obstacle that is suspended above the ground and has a suspension height smaller than the height of the cleaning robot, which may lead to collision. In addition, with the above obstacle avoidance solution, the distance of the linear laser that hits the ground is relatively long, generally exceeding 200 mm. At this distance, the distance measurement using the triangulation distance measurement principle is relatively low in accuracy and obstacles with small heights cannot be identified, which may lead to collision.

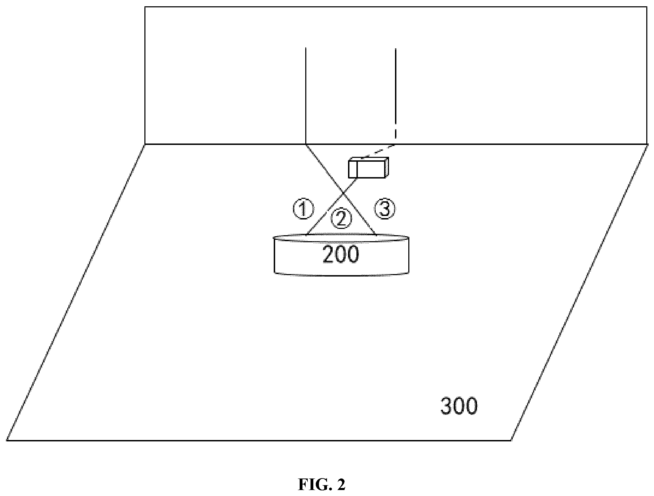

FIG. 2 is a schematic diagram of an obstacle avoidance scene of cleaning equipment provided by some embodiments of the present disclosure. As shown in FIG. 2, automatic cleaning equipment 200, such as a sweeping robot, automatically walks on a working surface 300, for example, the ground. The automatic cleaning equipment 200 performs obstacle avoidance using vertical double-line lasers for obstacle avoidance. The linear laser obstacle avoidance apparatus emits two linear lasers perpendicular to the ground. If there is an obstacle on either of the vertical linear laser paths, the laser will form a bend point. By comparing with the part of the linear laser that hits the ground, the distance to and the height of the obstacle can be determined, and the obstacle can be avoided based on the distance and height information.

With the above obstacle avoidance solution, there are blind zones in the horizontal direction, such as the positions ①, ②, and ③ in FIG. 2, where the line lasers cannot cover. If there is an obstacle at any of these positions, the mobile robot may fail to avoid it and collision may occur. The vertical double-line laser solution requires two single-line laser devices to be assembled on two sides of the center line of the cleaning robot. The cost of the two single-line laser devices is relatively high, and the mounting and debugging are complex.

In the related art, more accurate obstacle avoidance can be achieved by increasing the number of line laser apparatuses, and for example, by using a combination of horizontal linear lasers and vertical linear lasers to achieve multi-line laser obstacle avoidance. However, adopting this obstacle avoidance solution will increase the number of line laser devices, resulting in higher cost.

The present disclosure provides a multi-line laser device. The multi-line laser device includes: a substrate, N laser light sources being arranged on the substrate, wherein N is a positive integer and N is greater than or equal to 2; a collimating component, configured to collimate lasers emitted by the laser light sources; and a shaping component, the shaping component including N shaping regions which are configured to shape N collimated lasers emitted by the N laser light sources respectively to form multiple linear lasers. The multi-line laser device is formed by integration technology, the plurality of laser light sources is integrated on the same substrate, and the lasers emitted by the respective laser light sources correspond to different regions of the same shaping component and are shaped to form different linear lasers, thereby reducing the size and cost of the multi-line laser device.

The optional embodiments of the present disclosure will be described in detail below with reference to the accompanying drawings.

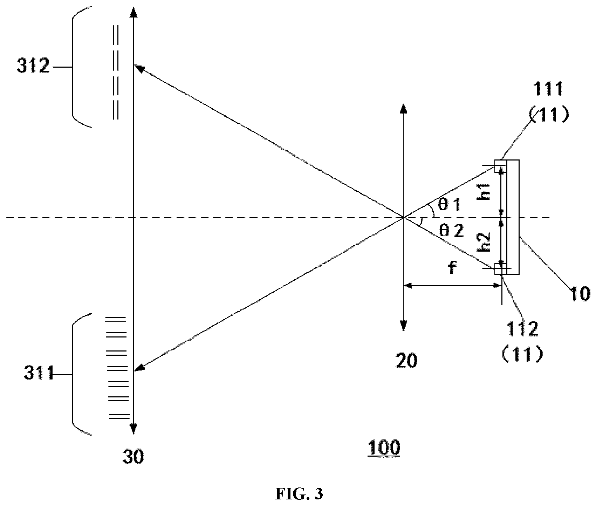

FIG. 3 is a schematic structural diagram of a multi-line laser device provided by some embodiments of the present disclosure. As shown in FIG. 3, a multi-line laser device 100 is provided by some embodiments of the present disclosure, is configured to emit a plurality of linear lasers, and may be arranged on cleaning equipment 200 for performing an obstacle avoidance operation. The multi-line laser device 100 includes a substrate 10, a collimating component 20 and a shaping component 30.

The substrate 10 is, for example, a ceramic substrate, and N laser light sources 11 are arranged on the substrate 10, wherein N is a positive integer and N is greater than or equal to 2. The laser light source 11 is configured to emit a point-shaped laser beam, and two laser light sources 11, namely a first laser light source 111 and a second laser light source 112, are exemplarily shown in FIG. 3. Each of the first laser light source 111 and the second laser light source 112 emits a point-shaped laser beam. In some embodiments, as shown in FIG. 3, the first laser light source 111 and the second laser light source 112 are located at two opposite ends of the substrate 10, respectively.

In some embodiments, the laser light source 11 includes, but is not limited to, a vertical-cavity surface-emitting laser (VCSEL) light source and/or an edge emitting laser (EEL) light source. The wavelengths of the lasers emitted by the laser light sources 11 include but are not limited to 808 nm, 850 nm, 905 nm and/or 940 nm, and the like. N laser light sources 11 are integrally bonded on the substrate 10, and their types, powers and wavelengths may be the same or different.

In some embodiments, the laser light sources 11 may be connected to a common anode or a common cathode, and the other end of each laser light source 11 is connected to a light source driving circuit.

The collimating component 20 is configured to collimate the lasers emitted by the laser light sources 11, so as to avoid divergence of point-shaped lasers. The collimating component 20 is, for example, a collimating lens or a collimating lens group. The collimating lens is, for example, a plano-convex lens. In some embodiments, the materials of the collimating lens or the collimating lens group include, but are not limited to, polycarbonate (PC), polymethylmethacrylate (PMMA) and/or glass, and the surface of the collimating lens or the collimating lens group may be evaporated with an antireflection film to increase the utilization rate of the lasers.

The shaping component 30 includes N shaping regions 31 which are configured to shape N collimated lasers emitted by the N laser light sources 11 respectively to form multi-line lasers. Two shaping regions 31, namely a first shaping region 311 and a second shaping region 312, are exemplarily shown in FIG. 3, and are corresponding to the first laser light source 111 and the second laser light source 112, respectively. In some embodiments, as shown in FIG. 3, the first shaping region 311 and the second shaping region 312 are located at two ends of the shaping component 30, respectively. The first shaping region 311 receives a first point-shaped laser emitted by the first laser light source 111 and shapes the first point-shaped laser into a first linear laser. The second shaping region 312 receives a second point-shaped laser emitted by the second laser light source 112 and shapes the second point-shaped laser into a second linear laser.

In the present disclosure, the point-shaped laser means that the form of the cross section of the laser in the direction perpendicular to its propagation direction is point-shaped, while the linear laser means that the form of the cross section of the laser in the direction perpendicular to its propagation direction is linear.

In some embodiments, each of the N shaping regions 31 is one of the vertical shaping region, horizontal shaping region and inclined shaping region. The vertical shaping region can shape the point-shaped laser into a vertical linear laser for emission, and the vertical linear laser means that the line form of the cross section of the laser in the direction perpendicular to its propagation direction is perpendicular to the ground. The horizontal shaping region can shape the point-shaped laser into a horizontal linear laser for emission, and the horizontal linear laser means that the line form of the cross section of the laser in the direction perpendicular to its propagation direction is parallel to the ground. The inclined shaping region can shape the point-shaped laser into an inclined linear laser for emission, and the inclined linear laser means that the line form of the cross section of the laser in the direction perpendicular to its propagation direction is inclined to the ground. The inclined linear laser may include a plurality of line forms with different inclination angles, such as 30°, 45° and 60°.

In some embodiments, as shown in FIG. 3, the first shaping region 311 is, for example, the vertical shaping region, and can shape the first point-shaped laser, which is emitted from the first laser light source 111 and collimated by the collimating component 20, into a vertical linear laser and emit the vertical linear laser, that is, the first linear laser is the vertical linear laser. The second shaping region 312 is, for example, the horizontal shaping region, and can shape the second point-shaped laser, which is emitted from the second laser light source 112 and collimated by the collimating component 20, into a horizontal linear laser and emit the horizontal linear laser, that is, the second linear laser beam is the horizontal linear laser.

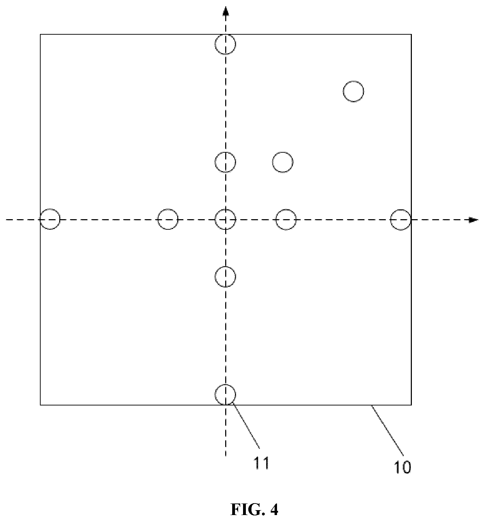

FIG. 4 is a schematic structural diagram of a substrate provided by some embodiments of the present disclosure, which exemplarily shows the positions of laser light sources on the substrate. A coordinate system is constructed in the surface of the substrate, for example, as shown in FIG. 4, with the midpoint of the substrate as the origin, the horizontal direction as the X axis direction and the vertical direction as the Y axis direction. Thus, the setting positions of the laser light sources 11 on the substrate 10 can be clearly and precisely identified. The coordinates of each laser light source 11 in the coordinate system can represent the position of the laser light source 11 on the substrate 10.

In some embodiments, as shown in FIG. 4, the substrate 10 is, for example, square. In other embodiments, the substrate may be rectangular, rhombic, circular and in other shapes.

In some embodiments, the laser light source 11 may be arranged at any position on the substrate 10. FIG. 4 shows some positions of the laser light sources 11 on the substrate 10. For example, the laser light sources 11 may be arranged along the X axis, arranged along the Y axis or arranged on the diagonal of the square substrate 10. Some positions of the laser light sources 11 shown in FIG. 4 on the substrate 10 are exemplary and not exhaustive. It can be understood by those skilled in the art that the laser light sources 11 may also be arranged at other positions on the substrate 10.

In some embodiments, light spots, formed by the lasers emitted by the laser light sources 11 that pass through the collimating component 20 and are then projected onto the shaping component 30, fall into the shaping regions 31 corresponding to the laser light sources 11. The number of the laser light sources 11 is the same as the number of the shaping regions 31 of the shaping component 30, and the laser light sources 11 are in one-to-one correspondence with the shaping regions 31 of the shaping component 30. The light spot, formed by the point-shaped laser emitted by each laser light source 11 that is collimated by the collimating component 20 and then is irradiated onto the shaping component 30, is located in the shaping region 31 corresponding to the laser light source 11. The shaping region 31 can shape the received collimated point-shaped laser into a linear laser and emit the linear laser.

In some embodiments, the position and the size of the light spot are determined by at least one of a position and a light emitting direction of the laser light source 11 corresponding to the light spot, a characteristic of the collimating component 20, and the distance between the collimating component 20 and the shaping component 30. As shown in FIGS. 3 and 4, the positions of the laser light sources 11 on the substrate 10, the light-emitting direction, the division of the shaping regions 31 on the shaping component 30, and the relative positional relationship among the substrate 10, the collimating component 20 and the shaping component 30 can be designed according to actual needs, such that the point-shaped laser emitted by each laser light source 11 almost completely falls into the shaping region 31 corresponding to the laser light source 11, thereby obtaining a plurality of expected linear lasers.

In some embodiments, as shown in FIG. 3, the substrate 10 and the shaping component 30 are located on two sides of the collimating component 20 respectively, and the substrate 10 is located on the focal plane of the collimating component 20, and is arranged to be perpendicular to the optical axis of the collimating component 20. With this arrangement, after passing through the collimating component 20, the point-shaped lasers emitted by the laser light sources 11 on the substrate 10 can form a collimated parallel beam, thereby overcoming the divergence problem of the point-shaped lasers emitted by the laser light sources 11. In some embodiments, as shown in FIG. 3, the center of the substrate 10 is located on the optical axis of the collimating component 20. In some embodiments, the substrate 10 includes a plurality of laser light sources, and the central symmetry points of two of the laser light sources are located on the optical axis of the collimating component 20.

In some embodiments, as shown in FIG. 3, the first laser light source 111 emits a first point-shaped laser toward the center of the collimating component 20, and the beam inclination angle of the first point-shaped laser is θ1 =arctg h1/f, wherein h1 represents the distance between the first laser light source 111 and the midpoint of the substrate 10, namely, the distance between the first laser light source 111 and the optical axis of the collimating component 20; and f represents the focal length of the collimating component 20. During the transmission of the first point-shaped laser from the first laser light source 111 to the collimating component 20, due to the divergence angle of the first laser light source 111, the light spot of the first point-shaped laser in the direction perpendicular to its transmission direction gradually expands as it moves away from the first laser light source 111, and the first point-shaped laser gradually diverges. After passing through the collimating component 20, such as a collimating lens, the first point-shaped laser forms a collimated parallel beam, and the size of the light spot of the collimated first point-shaped laser in the direction perpendicular to its transmission direction remains unchanged, that is, the first point-like laser no longer diverges. When the collimated first point-shaped laser reaches the shaping component 30, the light spot formed by the first point-shaped laser projected onto the shaping component 30 falls into the first shaping region 311 corresponding to the first laser light source 111, and the light spot area is less than or approximately equal to the area of the first shaping region 311. The collimated first point-shaped laser is shaped by the first shaping region 311, for example, to form a vertical linear laser, and the vertical linear laser is emitted.

In some embodiments, as shown in FIG. 3, the second laser light source 112 emits a second point-shaped laser toward the center of the collimating component 20, and the beam inclination angle of the second point-shaped laser is θ2 =arctg h2/f, wherein h2 represents the distance between the second laser light source 112 and the midpoint of the substrate 10, namely, the distance between the second laser light source 112 and the optical axis of the collimating component 20; and f represents the focal length of the collimating component 20. During the transmission of the second point-shaped laser from the second laser light source 112 to the collimating component 20, due to the divergence angle of the second laser light source 112, the light spot of the second point-shaped laser in the direction perpendicular to its transmission direction gradually expands as it moves away from the second laser light source 112, and the second point-shaped laser gradually diverges. After passing through the collimating component 20, such as the collimating lens, the second point-shaped laser forms a collimated parallel beam, and the size of the light spot of the collimated second point-shaped laser in the direction perpendicular to its transmission direction remains unchanged, that is, the second point-like laser no longer diverges. When the collimated second point-shaped laser reaches the shaping component 30, the light spot formed by the second point-shaped laser projected onto the shaping component 30 falls into the second shaping region 312 corresponding to the second laser light source 112, and the light spot area is less than or approximately equal to the area of the second shaping region 312. The collimated second point-shaped laser is shaped by the second shaping region 312, for example, to form a horizontal linear laser, and the horizontal linear laser is emitted.

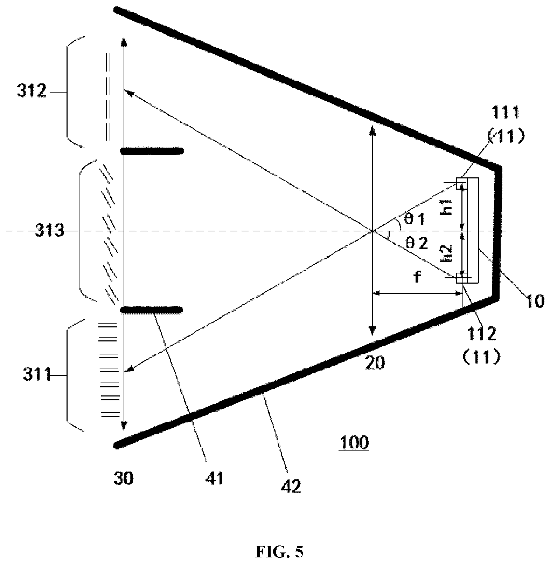

FIG. 5 is a schematic structural diagram of a multi-line laser device provided by some embodiments of the present disclosure. The partial structure of the multi-line laser device shown in FIG. 5 is the same as the structure of the multi-line laser device shown in FIG. 3, and the same part will not be repeatedly described herein. The following specifically describes the differences between the two.

As shown in FIG. 5, three shaping regions 31 are exemplarily shown in FIG. 5, namely, a first shaping region 311, a second shaping region 312 and a third shaping region 313. The first shaping region 311, the third shaping region 313 and the second shaping region 312 are sequentially adjacent to each other in the longitudinal direction. The first shaping region 311 receives a first point-shaped laser emitted by a first laser light source 111 and shapes the first point-shaped laser into a first linear laser, such as a vertical linear laser. The second shaping region 312 receives a second point-shaped laser emitted by a second laser light source 112 and shapes the second point-shaped laser into a second linear laser, such as a horizontal linear laser. The third shaping region 313 may receive a third point-shaped laser emitted by a third laser light source and shapes the third point-shaped laser into a third linear laser, such as an inclined linear laser.

In some embodiments, an extinction device 41, such as an extinction plate, is arranged between the adjacent shaping regions 31. The extinction device may be made of a metal or non-metal material. The metal material, for example, may be aluminum alloy and is blackened for an optical purpose. The non-metal material, for example, may be PC, PPS, PET or the like, and is blackened for an optical purpose. The surface of the extinction device is treated for extinction, such as by providing extinction threads or spraying an extinction paint. Specifically, as shown in FIG. 5, the extinction devices 41 are arranged between the first shaping region 311 and the third shaping region 313 and between the second shaping region 312 and the third shaping region 313, are basically parallel to the optical axis of the shaping component 30, and for example, extend from the shaping component 30 toward the collimating component 20, so as to block, reflect and absorb stray light generated after the collimated laser beam is incident on the shaping regions 31, and meanwhile, prevent the stray light from causing crosstalk between the adjacent shaping regions 31.

In some embodiments, as shown in FIG. 5, the multi-line laser device 100 may further include an extinction cylinder 42 configured to accommodate the substrate 10, the collimating component 20 and the shaping component 30. The extinction cylinder 42 may be made of a metal or non-metal material. The metal material, for example, may be aluminum alloy and is blackened for an optical purpose. The non-metal material, for example, may be PC, PPS, PET or the like, and is blackened for an optical purpose. The surface of the inner wall of the extinction cylinder 42 is treated for extinction, such as by providing extinction threads or spraying an extinction paint, so as to absorb stray light in front of and behind the collimating component 20 and stray light that the extinction device 41 fails to eliminate, thereby improving the laser output quality of the multi-line laser device.

As shown in FIG. 5, the end of the extinction cylinder 42 near the shaping component 30 is open, and the linear laser generated by the multi-line laser device is emitted through the opening. The end of the extinction cylinder 42 near the substrate 10 is closed, which prevents external light from entering the extinction cylinder 42 and adversely affecting the operation of the multi-line laser device. In other embodiments, the end of the extinction cylinder 42 near the substrate 10 may also be open.

In some embodiments, at least some of the laser light sources 11 are configured to emit lasers at different time and/or emit lasers simultaneously. With reference to FIGS. 3 to 5, the laser light sources 11 on the substrate 10 may be controlled by a light source driving circuit. The light source driving circuit may be an external driving circuit connected externally or an internal driving circuit integrated on the substrate 10. The light source driving circuit can control the emission time and continuous pulse width of each laser light source, so as to control the emission of the linear laser corresponding to each laser light source.

In some embodiments, according to design requirements, the laser light sources 11 may be configured to emit lasers at different time, such that the emitted linear lasers do not interfere with each other.

In some embodiments, according to the design requirements, the laser light sources 11 may be configured to emit lasers simultaneously, which can improve the detection efficiency of the linear lasers.

In some implementations, according to design requirements, some of the laser light sources 11 may be configured to emit lasers at different time, while other laser light sources may be configured to emit lasers simultaneously.

In some embodiments, the laser light sources corresponding to mutually parallel linear lasers emit lasers simultaneously; and the laser light sources corresponding to mutually intersecting linear lasers emit lasers at different time. For example, the laser light sources corresponding to a plurality of parallel linear lasers emit lasers simultaneously, the laser light sources corresponding to a plurality of vertical linear lasers emit lasers simultaneously, and the laser light sources corresponding to a plurality of inclined linear lasers with the same inclination angle emit lasers simultaneously. The laser light sources corresponding to the parallel linear laser, the vertical linear laser and the inclined line laser emit lasers at different time, and pulses of the lasers emitted by these laser light sources do not overlap if there is an interval between their laser emission time. In some embodiments, the shaping region includes at least one of a Powell prism, a cylindrical mirror and a wave mirror. Taking the wave mirror as an example, the wave shapes corresponding to the different shaping regions 31 may be the same or different. The shaping characteristics of the shaping regions 31 are related to the wave shapes. For example, a shaping region with a wave shape extending in the horizontal direction can shape a point-shaped laser into a vertical linear laser, and a shaping region with a wave shape extending in the vertical direction can shape a point-shaped laser into a horizontal linear laser.

In the present disclosure, by the chip bonding technology and the optimized optical lens design, the size of the multi-line laser device can be greatly reduced, thereby reducing the integration difficulty. The multi-line laser device achieves the multi-line solution by increasing the number of laser light source chips on the ceramic substrate, without significant increase in the cost of optical lenses and structural parts.

Some embodiments of the present disclosure provide cleaning equipment including the multi-line lase device 100 described in the foregoing embodiments.

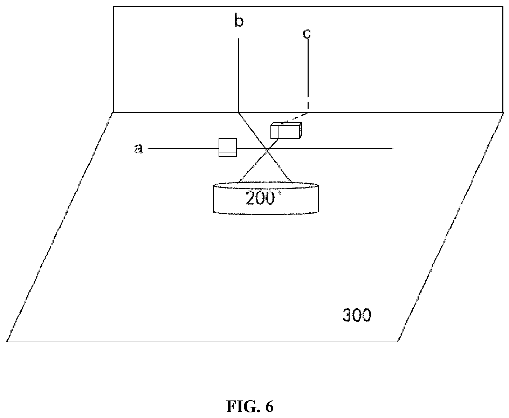

FIG. 6 is a schematic diagram of an obstacle avoidance scene of cleaning equipment provided by some embodiments of the present disclosure. As shown in FIG. 6, automatic cleaning equipment 200', such as a sweeping robot, automatically walks on a working surface 300, for example, the ground. The automatic cleaning equipment 200' performs obstacle avoidance using a horizontal single-line laser combined with vertical double-line lasers for obstacle avoidance. As shown in FIG. 6, a represents a horizontal line laser, and b and c represent vertical linear lasers. In other embodiments, the automatic cleaning equipment 200' may also be additionally provided with an inclined linear laser for obstacle avoidance. Using different linear lasers to perform obstacle avoidance can eliminate blind zones in obstacle avoidance, and meanwhile, improve the accuracy of obstacle avoidance.

Finally, it should be noted that various embodiments in the Description are described in a progressive manner, each embodiment focuses on the differences from other embodiments, and the same or similar parts among the various embodiments may refer to one another. Since the system or apparatus disclosed in the embodiments corresponds to the method disclosed in the embodiments, its description is relatively simple, and for the relevant parts, reference may be made to the descriptions of the method embodiments.

The above embodiments are only used for illustrating the technical solutions of the present disclosure and are not intended to limit the present disclosure. Although the present disclosure has been described in detail with reference to the foregoing embodiments, those of ordinary skills in the art should understand that, they can still make modifications to the technical solutions described in the foregoing embodiments or make equivalent substitutions to part of the technical features; and these modifications or substitutions do not make the essence of the corresponding technical solutions deviate from the spirit and scope of the technical solutions of the various embodiments of the present disclosure.

## Claims

1. A multi-line laser device, comprising:
a substrate, N laser light sources being arranged on the substrate, wherein N is a positive integer and N is greater than or equal to 2;
a collimating component, configured to collimate lasers emitted by the laser light sources; and
a shaping component, the shaping component comprising N shaping regions which are configured to shape N collimated lasers emitted by the N laser light sources respectively to form linear lasers.

2. The multi-line laser device according to claim 1, wherein each of the N shaping regions is one of a vertical shaping region, a horizontal shaping region and an inclined shaping region.

3. The multi-line laser device according to claim 1 or 2, wherein light spots, formed by the lasers emitted by the laser light sources that pass through the collimating component and are then projected onto the shaping component, fall into the shaping regions corresponding to the laser light sources.

4. The multi-line laser device according to claim 3, wherein a position and a size of the light spot are determined by at least one of a position and a light emitting direction of the laser light source corresponding to the light spot, a characteristic of the collimating component, and a distance between the collimating component and the shaping component.

5. The multi-line laser device according to claim 1 or 2, wherein the substrate and the shaping component are located on two sides of the collimating component respectively, the substrate is located on a focal plane of the collimating component, and the substrate is arranged to be perpendicular to an optical axis of the collimating component.

6. The multi-line laser device according to claim 5, wherein a center of the substrate or a centrosymmetric point of two laser light sources on the substrate is located on the optical axis of the collimating component.

7. The multi-line laser device according to claim 1 or 2, wherein an extinction device is arranged between adjacent shaping regions.

8. The multi-line laser device according to claim 1 or 2, further comprising: an extinction cylinder configured to accommodate the substrate, the collimating component and the shaping component.

9. The multi-line laser device according to claim 1 or 2, wherein at least some of the laser light sources are configured to emit lasers at different time and/or emit lasers simultaneously.

10. The multi-line laser device according to claim 9, wherein the laser light sources corresponding to mutually parallel linear lasers emit lasers simultaneously; and the laser light sources corresponding to mutually intersecting linear lasers emit lasers at different time.

11. The multi-line laser device according to claim 1 or 2, wherein the shaping region comprises at least one of a Powell prism, a cylindrical mirror and a wave mirror.

12. Cleaning equipment, comprising the multi-line laser device according to any one of claims 1 to 11.
